# EUROPEAN PATENT APPLICATION

(11) **EP 3 024 146 A1**
(43) Date of publication of application: **25.05.2016**
(21) Application number: 14193710.2
(22) Date of filing: 18.11.2014
(51) Int. Cl.: H03M 7/30, H03M 7/46, H03M 7/48

(54) **Compression by rotation indexing**

(71) Applicant: ALCATEL LUCENT, 92100 Boulogne-Billancourt (FR)
(72) Inventor: Jacquet, Philippe, 91620 Nozay (FR); Burnside, Gérard, 91620 Nozay (FR)
(74) Representative: Cabinet Camus Lebkiri

(57) **Abstract**

Method for data communication with lossless data compression comprising the following steps:
- transform an original text into a syntaxic graph for the text and a rotation index for the graph,
- transmit the graph with the rotation index and
- transform the syntaxic graph and the rotation index into the original text.

## Description

This disclosure concerns the general domain of lossless data compression, decompression and transmission methods and the use of such methods to increase the useful data throughput of a communication channel without increasing its bandwidth. This disclosure can be applied, more peculiarly, to increase the number of IP packets transmitted by an IP communication network having a given bandwidth.

A data communication method with lossless data compression comprises usually in prior art, a data compression step, a data transmission step and a data decompression step. The input of such a method is an original text of length L0. At first, the original text is transformed into a first text of length L1, inferior to L0, by the compression step, thanks to a lossless compression algorithm. Then, the first text is transmitted at the transmission step over a data communication channel of given bandwidth, i.e. the first text is emitted from a first place and received in a second place distinct from the first place, as a received second text identical to the emitted first text, when no transmission errors are encountered. Finally, the second text is transformed at the decompression step into a third text identical to the original text (i.e. a same length, same bits and a same order for the letters in both these texts). Such a communication method faces the problem to provide a L1 inferior to L0, whatever the original text used as input for the lossless compression algorithm. However because the input texts may be of arbitrary short length, this problem appears to be difficult for existing algorithms.

Indeed, in prior art, the lossless compression algorithms are in general inefficient on short or medium sized texts. Such inefficiency is, for instance, revealed by the fact that for a given short or medium sized text, the compressed text may have more bits than the original text. For instance, the Lempel-Ziv algorithms and derived (e.g. Lempel-Ziv-Renau), Huffman algorithm and derived (e.g. arithmetic coding) are widespread classes of lossless compression, in the art prior to this disclosure. They are based on the actual detection of repeated pattern in the text to be compressed. For small texts, the compressed output of these algorithms is known to be sometimes bigger than the uncompressed input.

There is therefore a need in prior art for a compression algorithm which is effective on short or medium sized texts as well as on large texts.

Within this context, this disclosure concerns a method for lossless data compression comprising the following steps:
- transform an original text into a syntaxic graph for the text and a rotation index for the graph,
- emit the graph with the rotation index.

This disclosure concerns also:
- a device programmed to perform the above method.
- a communication network adapted to perform the above method.
- an IP Communication network adapted to perform the above method.
- a node of a communication network adapted to perform the above method.
- a data storage device encoding a machine executable program that performs the above method.

This disclosure concerns also a method for lossless data decompression comprising the following steps:
- receive a syntaxic graph for an original text with a rotation index for the graph,
- transform the syntaxic graph and the rotation index into the original text.

This disclosure concerns also:
- a device programmed to perform the above method.
- a communication network adapted to perform the above method.
- an IP Communication network adapted to perform the above method.
- a node of a communication network adapted to perform the above method.
- a data storage device encoding a machine executable program that performs the above method.

This disclosure concerns also a method for data communication with lossless data compression comprising the following steps:
- transform an original text into a syntaxic graph for the text and a rotation index for the graph,
- transmit the graph with the rotation index and
- transform the syntaxic graph and the rotation index into the original text.

This disclosure concerns also:
- a communication network adapted to perform the above method.
- an IP Communication network adapted to perform the above method.

The teaching of the present disclosure is described below.

The general idea of this disclosure is to transmit a syntaxic graph of a text with its rotation index.

Conforming to this idea, in order to communicate an original text from a first place to a second place, the present disclosure teaches to:
- compress at the first place the original text as a syntaxic graph and a rotation index for the graph,
- transmit the graph with the rotation index to the second place via a channel for information transmission, the channel having a given bandwidth,
- and re-build at the second place, the original text from the syntaxic graph and the rotation index with an induced minimized used of the bandwidth of the channel.

In a communication network, the implementation of the above idea comprises the steps of compressing at a first place of the network an original text as a syntaxic graph and a rotation index for the graph, transmitting the graph with the rotation index over the network and re-building at a second place of the network, the original text from the syntaxic graph and the rotation index with a minimized used of the bandwidth of the network.

Since the logarithm of the number of rotations is smaller than the entropy of the original text and the syntaxic graph description is of order log(L), L being the length of the text, the associated compression is very close to optimal with a redundancy rate of order log(L)/L.

Such a compression algorithm based on rotation indexing has the advantage of being more efficient on short texts than existing algorithms and therefore can be applied usefully to each IP packet at a network layer.

To the end of this disclosure, a letter is defined as a symbol, which can be associated to a number representative of the position of the symbol in an alphabet consisting of a set of symbols admitting a lexicographic order. In binary notation, a letter is usually associated to a unique bit sequence, the length of the sequence being in relationship with the number of letters in the chosen alphabet.

To the end of this disclosure, a text is intended to mean a sequence of letters, independently of the meaning associated to this text by a human reader or associated to the meaning of this text in terms of instructions for a machine. For instance a text may so consist in binary data contained in an IP packet of an IP network.

Under these definitions, the system is the following:

### TERMINOLOGY:

n - gram: text of n consecutive symbols extracted from a given text T.

n - syntax graph: A multi-graph G(V, E), whose vertex set contains all possible n-grams of a given text T. The edge set contains the possible edges that connect an n-gram A with another n-gram B if and only if B follows A in the original text. B is obtained after a translation of one symbol of N-grams A in the real text. For example, in the text T = ABCD, the 3-grams "BCD" follow the 3-grams "ABC" and the 3 syntax graph contains the edge (ABC, BCD). We also refer to such a graph throughout this document as a syntaxic graph.

In the following we assume that there exists an order between n-grams, for instance the lexicographic order.

### Description of the compression algorithm used:

The text to compress is T of length L=L(T). We first select the n-gram size r_0. Build the syntaxic graph G(T) over the n-grams of T. Let V=V(T,r_0) be the number of n-grams of length r_0 of text T.

Let the n-gram number i, we denote k_{ij} the number of outgoing edges from n-gram i to n-gram j. Let k_i=k_{i1}+...+k_{iV}. We consider the permutations over the outgoing edges. We don't distinguish edges to the same n-gram. There are B_i=k_i!/(k_{i1}!×...×k_{iV}!) such permutations for n-gram i.

We call a rotation a V-tuple (σ_1..., σ_V) where σ_i is a permutation on the outgoing edges of n-gram number i. A permutation σ_i can be given by a k_i-tuple made of k_{i1} 1's, k_{i2} 2's, ..., k_{iV} V's indicating the order at which the edges must be taken when departing the n-gram number i.

### Populating the permutations

In this phase the compression program populates the permutation tuples. Doing so for each n-gram i, the program initializes σ_i to null. Then it reads the text T. Every time it encounters the n-gram i, it updates σ_i: if the next n-gram in the text after a translation of one symbol is the n-gram of number j, then the program adds the integer j to σ_i list: σ_i= (σ_i,j).

### Encoding the permutations

From each t-uple σ_i one creates a number n_i<B_i in the following way:

```
 Procedure Permutation2Number(σ_i,){
 N_i=0;
 B_i=1;
 For j from 1 to V do {k_{ij}=0;}
 K_i=0;
 For k from 1 to length(σ_i) do{
   j= σ_i[length(σ_i)-k+1];
   K_i=K_i+1;
   k_{ij}=k_{ij}+1;
   B_i= K_i/k_{ij}B_i;
    For j' from 1 to j-1 do {n_i= n_i + B_i * k_{ij'}/k_i;}
   }
 return(n_i);
 }
```

### From the permutations to the rotation index

The program then produces the number N(T) from the tuple of numbers (n_1,...,n_V). N(T) denotes the index of the rotation on the syntaxic graph creating the text T and we have N(T)<B(T).

```
 Procedure Rotation2Number(n_1,...,n_V){
 N=0;
 For k from V down to 1 do {N=n_{k}+N×B_{k};}
 return(N);
 }
```

### Creating the compressed file

The compressed file or code is made of two elements: (i) the description of the syntaxic graph G(T) (ii) the rotation index N(T).

The rotation index being a number is encoded on log(B(T)) bits.

This code will be emitted for a data compression method in relation with this disclosure, will be received for a data decompression method in relation with this disclosure and will be transmitted for a data communication method in relation with this disclosure.

The syntaxic graph G(T) is encoded as follows. First, one encodes the number r_0 on one octet, and then the length L in two octets. Then the syntaxic graph is made of several type lines. A type line is made of one pair (n-gram number i, k_i) followed by a list of pairs (last symbol of n-gram j,k_ij). The quantity k_i is encoded on log(L) bits and the k_ij's on log(k_i) bits. Only the non zero values are listed. The line terminates when all the k_ij's sum to k_i. The first type line will be about the first n-gram of text T, indicating how to start the text on the decompression side.

In maximum the syntaxic graph is encoded in log(L)V^2 elements.

To the end of the present disclosure, the compression algorithm above can be implemented in a first node of an IP communication network, by computation means known in the art.

Once a text has been compressed in the first node, it can be encapsulated in IP packets and sent from the first node to a second node of the IP network, by communications means known in the art.

Once the compressed text or code has been received at the second node, means for decompressing the code, as for instance computation means known in the art, can be used to recover or re-build without loss of letters or lossless, the original text.

### Decompressing the code

The syntaxic graph part of the code lets the receiver know r_0, and the length LO. It helps build the syntaxic graph.

### From rotation index to permutation indices

It is now disclosed how to transform N=N(T) (obtained in the second part of the code) into a tuple (n_1...,,n_V) with each number n_i<B_i with B_i denoted as the number of possible permutations on the outgoing edges of n-gram i.

```
 Procedure SplitRotation(N){
 For i from 1 to V do{
  n_i=N mod B_i;
  N=(N-n_i)/B_i;
 }
 return(n_1,...,n_V);
 }
```

### From permutation index to permutation tuple

On n-gram number i we assume that a number n_i smaller than B_i is given. Here we describe a way to use the number n_i in order to populate a k_i-tuple σ_i with integers between 1 and V.

```
 Procedure SplitPermutation(n_i,k_{i1},...,k_{iV}){
 k_i=k_{i1}+...+k_{iV};
 B_i= k_i!/(k_{i1}!×...×k_{iV}!);
 For k from 1 to k_i do {
  J=1;
  While(k_{ij}=0 or n_i>= B_i * k_{ij}/k_i do{
     N_i=n_i- B_i * k_{ij}/k_i;
     j=j+1;
     }
  σ_i[k]=j;
 B_i = B_i * k_{ij} / k_i
  k_{ij}=k_{ij}-1;
  k_i=k_i-1;
  }
 return(σ_i);
 }
```

### Reproducing the text

The program starts with the first n-gram appearing in the syntaxic graph description, assume it is n-gram i0 in the lexicographic order. We initialize T=n gram i0. We consider the permutation tuple σ_i0. We move to n-gram i1= σ_i0[1] and we remove the first entry of σ_i0 (so the new first entry of σ_i0 is the former σ_i0[2]). We add to T the last symbol of n-gram i1 and we move to n-gram i2= σ_i1[1], add the last symbol of n-gram i2 to T and remove the first entry of σ_i1. The text is fully reconstructed when we arrive to an n-gram j with its current permutation tuple σ_j empty. At this time all n-grams shall have their permutation tuple empty.

### Examples :

### Consider the text:

T=aaaaaaaaaaaaaaaaaaaaaaaaaaaaaaaaaaaaaaaaaaaaaaaaaaaaaaaaaaaaaaaaaaaaaaaaaaaaaaaaaaaa aaaaaaaaaaaaaaaaaaaaaaaaaaaaaaaaaaaaaaaaaaaaaaaaaaaaaaaa (i.e. 140 times the letter a).

Then with r_0=1 the header will be (1,140). The syntaxic graph description will be (a,139)((a,139)). The index rotation will be 0 (only one rotation).

The compressed text will be (1,140)(a,139)((a,139)), number and characters are left as such and parentheses and comas are added for readability.

If we change the text to:
T=aaaaaaaaaaaaaaaaaaaaaaaaaaaaaaaaaaaaaaaaaaaaabaaaaaaaaaaaaaaaaaaaaaaaaaaaaaaaaaaaaa aaaaaaaaaaaaaaaaaaaaaaaaaaaaaaaaaaaaaaaaaaaaaaaaaaaaaaaaa (i.e. 140 letters, b at 46^{th} position and a everywhere else)

There are now 138 rotations and the rotation index of T is 93.

The compressed text will be: (1,140)(a,139)((a,138),(b,1))(b,1)((a,1))93

It appears that a benefit of this disclosure is so that it is possible to compress relatively short texts where the compression algorithms available in prior art need larger texts to become efficient. The above method can thus be usefully applied in replacement of Lempel-Ziv algorithms and derived (e.g. Lempel-Ziv-Renau), Huffman algorithm and derived (e.g. arithmetic coding) for data communication to save bandwith in communication channels.

Experiments comparing the disclosed method with the Lempel-Ziv-Renau one showed that better compression results are obtained. This is confirmed by theory since the above scheme has a redundancy rate of order log L/L and Lempel-Ziv schemes has a redundancy rate of order 1/log L (in memoryless text generation models, see Louchard, G., & Szpankowski, W. (1997), On the average redundancy rate of the Lempel-Ziv code. Information Theory, IEEE Transactions on, 43(1), 2-8.)

One advantage of the present disclosure when applied to a communication network, is to reduce the network communication energy consumption by reducing the amount of data transferred over the networks. As being able to compress short texts is generally recognized as an important criterion towards the goal of data transfer minimization in networks, the disclosed data compression, decompression or communication methods of this disclosure can be used in communication networks as IP networks. Such methods with their algorithms are therefore candidates for integration within a telecommunication standard and for being widely used by data communication industries.

Without departing from the teaching of the present disclosure, the skilled reader will understand that variations in the representation of the syntaxic graph could be made, and that as well the order of the type lines could be modified. Furthermore, it can be understood from the present disclosure that the algorithm of the disclosed method could also be modified to try several values of r_0 to find the optimal one for a given text, if enough computing power is, for instance, available for data compression.

The invention is susceptible of industrial application in communication networks.

The man skilled in the art will understand that the algorithms of the above disclosure operating on a text, can be equivalently performed either by reading the text from left to right to devise a syntaxic graph for the text or by reading the text from right to left to devise the syntaxic graph.

## Claims

1. Method for lossless data compression comprising the following steps:
- transform an original text into a syntaxic graph for the text and a rotation index for the graph,
- emit the graph with the rotation index.

2. Method for lossless data decompression comprising the following steps:
- receive a syntaxic graph for an original text with a rotation index for the graph,
- transform the syntaxic graph and the rotation index into the original text.

3. Method for data communication with lossless data compression comprising the following steps:
- transform an original text into a syntaxic graph for the text and a rotation index for the graph,
- transmit the graph with the rotation index and
- transform the syntaxic graph and the rotation index into the original text.

4. Device programmed to perform the method according to claim 1.

5. Communication network adapted to perform the method according to claim 1.

6. IP Communication network adapted to perform the method according to claim 1.

7. Node of a communication network adapted to perform the method according to claim 1.

8. Data storage device encoding a machine executable program that performs the method according to claim 1.

9. Device programmed to perform the method according to claim 2.

10. Communication network adapted to perform the method according to claim 2.

11. IP Communication network adapted to perform the method according to claim 2.

12. Node of a communication network adapted to perform the method according to claim 2.

13. Data storage device encoding a machine executable program that performs the method according to claim 2.

14. Communication network adapted to perform the method according to claim 3.

15. IP Communication network adapted to perform the method according to claim 3.
